## Europäisches Patentamt

## European Patent Office

## Office européen des brevets

(19)

(11) Veröffentlichungsnummer: **0 187 771**
**B1**

(12) **EUROPÄISCHE PATENTSCHRIFT**

(45) Veröffentlichungstag der Patentschrift:
**05.10.88**

(21) Anmeldenummer: **85902961.3**

(22) Anmeldetag: **11.06.85**

(86) Internationale Anmeldenummer:
**PCT/DE 85/00200**

(87) Internationale Veröffentlichungsnummer:
**WO 86/00749 (30.01.86** Gazette 86/3)

(51) Int. Cl.⁴: **H 01 F 17/00, H 03 H 7/09**

(54) **ELEKTRISCHER HOCHFREQUENZ-ÜBERTRAGER.**

(30) Priorität: **07.07.84 DE 3425153**

(43) Veröffentlichungstag der Anmeldung:
**23.07.86 Patentblatt 86/30**

(45) Bekanntmachung des Hinweises auf die Patenterteilung:
**05.10.88 Patentblatt 88/40**

(84) Benannte Vertragsstaaten:
**AT CH DE FR GB LI NL SE**

(56) Entgegenhaltungen:
**DE - A - 2 927 364**
**FR - A - 2 024 822**
**GB - A - 1 143 915**

(73) Patentinhaber: **ROBERT BOSCH GMBH, Postfach 50, D-7000 Stuttgart 1 (DE)**

(72) Erfinder: **PFIZENMAIER, Heinz, Liststr. 6, D-7250 Leonberg (DE)**
Erfinder: **SCHMIDT, Ewald, Bachstr. 10, D-7140 Ludwigsburg (DE)**

## Beschreibung

Die Erfindung geht aus von einem Hochfrequenz-Übertrager nach der Gattung des Hauptanspruchs. Aus der FR-A-2 024 822 ist ein Hochfrequenz-Übertrager bekannt, der eine um einen Ferritkern herum beidseitig auf einem Isolierträger angeordnete, eine Spule bildende planare Leiterbahnstruktur aufweist. Auf dem die planare Leiterstruktur tragenden Isolierträger sind an Masse angeschlossene Leiterbahnen aufgebracht. Diese Leiterbahnen stellen kapazitive Elemente dar, die eine kapazitive Verbindung zwischen den die Spule bildenden Leiterbahnen und Masse herstellen.

Ein weiterer bekannter Übertrager nach der DE-B-2 230 587 in gedruckter Technik hat einen blättchenförmigen Wicklungsträger aus elektrisch isolierendem Material mit mindestens einer auf den Wicklungsträger aufgebrachten, ebenen, spiralförmigen Wicklung und einem Magnetkern, dessen magnetischer Kreis mit dem elektrischen Kreis der Wicklung(en) verkettet ist. Der Ferritkern ist zweigeteilt, d. h. er weist im magnetischen Kreis einen Luftspalt auf. Damit lassen sich bei hohen Frequenzen im Megahertz-Bereich keine ausreichend hohen Induktivitäten erzielen, da höherpermeable Ferritsorten bei diesen Frequenzen eine geringe Permeabilität aufweisen.

Ferner gibt es Spulenanordnungen mit Mehrlochkern, bei denen auf einem Isolierträger zwei Spulenpaare in Form von gedruckten Leiterbahnen aufgebracht sind. Der Isolierträger ist innerhalb und/oder ausserhalb der Spulen mit Durchbrüchen versehen. Diese Durchbrüche werden mit ungesintertem Ferritmaterial gefüllt, und auf die Ober- und Unterseite des Isolierträgers wird Ferritmaterial aufgebracht. Anschliessend wird die gesamte Anordnung gesintert, so dass eine Spulenanordnung mit geschlossenem Ferritkern entsteht, die einen sehr kleinen magnetischen Streufluss hat (DE-A-2 917 388). Die hier angewandte Technik für die Herstellung des Ferritkernes ist jedoch aufwendig und lässt sich schwer beherrschen, d. h. die Übertragungseigenschaften der Spulenanordnung weisen in der Serie grosse Streuungen auf.

Schliesslich ist es durch die DE-A-2 830 732 bekannt, bei Spulen mit gedruckten Leiterbahnen parasitäre Wicklungskapazitäten zu verringern und die Grenzfrequenz der Spule zu erhöhen, indem der Isolationsabstand zwischen den Leiterbahnen mindestens in Teilbereichen nicht konstant ist. Damit ist jedoch kein geschlossener magnetischer Kreis zu erzielen, wie er für breitbandige Übertrager erforderlich ist.

Der erfindungsgemässe Übertrager mit den kennzeichnenden Merkmalen des Hauptanspruchs hat demgegenüber den Vorteil, dass die induktive Übertragung im unteren Frequenzbereich (einige Megahertz) kontinuierlich in eine Mikrostrip-Koppler-Übertragung im oberen Frequenzbereich (einige 100 Megahertz) übergeht. Der leitende Belag, der nicht weiter kontaktiert ist, hat die Wirkung von in Reihe geschalteten Kondensatoren, die Teile der Leiterbahnen und der Anschlüsse kapazitiv verbinden und dadurch alle Parameter des Übertragers im mittleren und oberen Frequenzbereich in gewünschter Richtung verändern. Durch entsprechende geometrische Ausbildung des leitenden Belags und der Dicke des Dielektrikums kann die Schaltung den bestehenden Bedürfnissen optimal angepasst werden. Damit lassen sich Übertrager in planarer Technik herstellen, die im mittleren und oberen Frequenzbereich deutlich bessere Werte aufweisen als herkömmliche, drahtgewickelte Übertrager.

Durch die in den Unteransprüchen aufgeführten Massnahmen sind vorteilhafte Weiterbildungen und Verbesserungen des im Hauptanspruch angegebenen Übertragers möglich. Besonders vorteilhaft ist es zur Erzielung einer einfachen Herstellungsweise, dass als Dielektrikum ein weiterer Isolierträger dient, welcher auf dem die Leiterbahnen aufweisenden Isolierträger z. B. durch Löten befestigt und mit dem leitenden Belag versehen ist. Hat der Übertrager einen Nachbildwiderstand, so wird dieser bevorzugt auf dem die Leiterbahnen aufweisenden Isolierträger angeordnet und mittels eines Streifenleiters an die Spulenanordnung angeschlossen. Durch die Verwendung eines solchen Streifenleiters mit bestimmten Parametern lässt sich im oberen Frequenzbereich ein höherer Dämpfungswert der Übertragung vom Stich zum Ausgang des Übertragers erzielen. Ferner ist es zweckmässig, dass der Nachbildwiderstand einen von dem Wellenwiderstand des Systems abweichenden Widerstandswert aufweist und dass ferner die Spulenanordnung mehrwindige Leiterbahnspiralen hat, deren äusseres Ende an Masse geht. Durch diese beiden Massnahmen lassen sich die Dämpfungswerte der Übertragung vom Stich zum Ausgang im unteren Frequenzbereich erheblich verbessern, wozu insbesondere die durch den Anschluss der äusseren Spulenenden an Masse realisierbaren unsymmetrischen Windungszahlverhältnisse der Spulen beitragen.

Ein Ausführungsbeispiel der Erfindung ist in der Zeichnung dargestellt und in der nachfolgenden Beschreibung näher erläutert. Es zeigen:

Fig. 1 den elektrischen Übertrager mit entlang der Linie II–II von Fig. 2 geschnittenen Isolierträgern;

Fig. 2 den Übertrager nach Fig. 1 in Draufsicht mit geschnittenem Ferritkern;

Fig. 3 ein NF-Ersatzschaltbild des Übertragers;

Fig. 4 und 5 Diagramme über den Verlauf verschiedener elektrischer Übertragungswerte im Vergleich mit Werten anders ausgebildeter Übertrager.

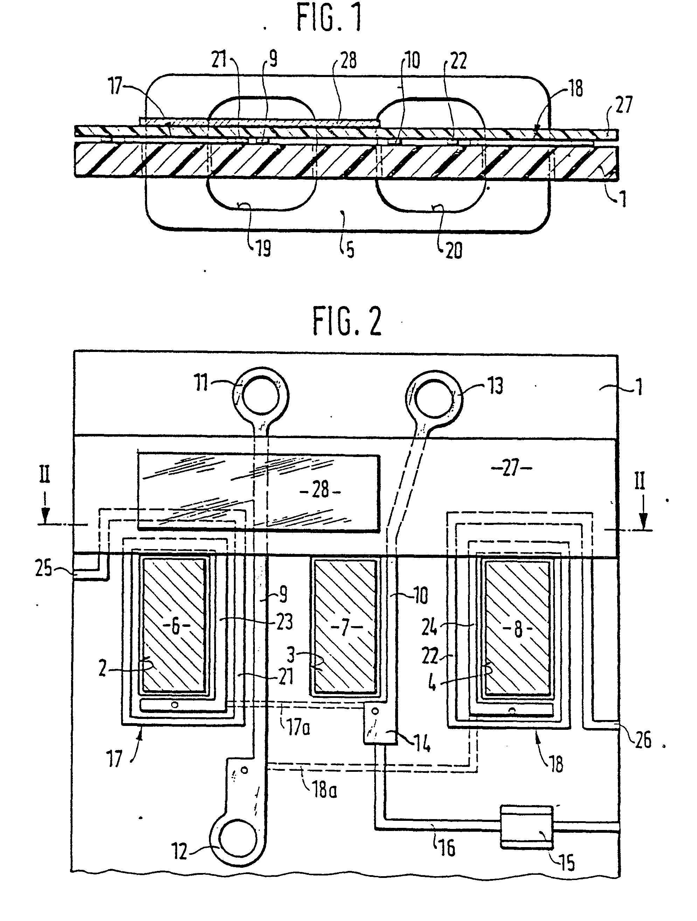

Der in den Fig. 1 und 2 dargestellte elektrische Übertrager hat einen Isolierträger 1, der aus einem an sich bekannten elastischen Material besteht, das hochisolierend ist und nach einer Verformung selbsttätig in seine Planlage zurückfedert. Der Isolierträger 1 hat drei rechteckförmige Durchbrüche 2, 3, 4 (Fig. 2) zur Aufnahme eines geschlossenen Zweiloch-Ferritkerns 5. Die Grösse der Durchbrüche ist an den Querschnitt der Kernschenkel 6, 7, 8 angepasst. Zum Einführen des Ferritkerns 5 in die Durchbrüche 2 bis 4 kann der Isolierträger 1 mit nicht dargestellten, aus der Ebene des Trägers aushebbaren federnden Zungen versehen sein, wie sie in der DE-A-3 322 004 beschrieben sind.

Auf der Oberseite des Isolierträgers 1 ist flächenhaft nach einem bekannten Verfahren eine Spulenanordnung in Form gedruckter Leiterbahnen aufgebracht. Im einzelnen besteht die Spulenanordnung aus zwei langgestreckten Leiterbahnen 9, 10, deren beide Enden mit Anschlüssen 11, 12 bzw. 13, 14 versehen sind. Der Anschluss 11 bildet den Eingang, der Anschluss 12 den Ausgang und der Anschluss 13 den Stich des Systems. Der Anschluss 14 der Leiterbahn 10 geht über einen Nachbildwiderstand 15 an Masse. Zur Verbindung des Anschlusses 14 mit dem Nachbildwiderstand 15 dient ein Streifenleiter 16.

Den Leiterbahnen 9, 10 ist je eine Leiterbahnspirale 17 bzw. 18 gegenübergestellt, die im Ausführungsbeispiel rechteckförmige Konfiguration hat und den Schenkel 6 bzw. 8 des Ferritkerns 5 umgibt. Die das Kernloch 19 bzw. 20 des Ferritkerns durchgreifenden Leiterbahnen 9, 10 haben, wie aus Fig. 2 ersichtlich, unterschiedliche Bahnbreite und einen unterschiedlichen Abstand von den ihnen gegenüberliegenden Abschnitten 21 bzw. 22 der Leiterbahnspiralen 17 bzw. 18. Vorzugsweise ist die Breite der Leiterbahn 10 kleiner als die Breite der Leiterbahn 9 und der Abstand der Leiterbahn 9 von dem ihr gegenüberliegenden Abschnitt 21 der Leiterbahnspirale 17 kleiner als der Abstand der Leiterbahn 10 vom Abschnitt 22 der Leiterbahnspirale 18. Ausserdem ist die Breite der das Kernloch 20 des Ferritkerns 5 durchgreifenden Abschnitte 22, 24 der Leiterbahnspirale 18 kleiner als die Breite der Leiterbahnabschnitte 21, 23 der Spirale 17 im Kernloch 19. Bei den Abständen von 22 zu 24 und 21 zu 23 verhält es sich umgekehrt. Die vorstehend erwähnten Parameter sind so gewählt, dass die Teile 9, 17 und 10, 18 jeweils einen modifizierten Streifenleiter-Koppler bilden, welche geometrisch ungleich (unsymmetrisch) sind.

Die beiden Leiterbahnspiralen 17, 18 haben entgegengesetzten Windungssinn, der von innen nach aussen so verläuft, dass das äussere Ende 25 bzw. 26 der Spiralen jeweils an Masse geht. Dadurch lassen sich unterschiedliche Windungszahlverhältnisse von 9 und 17, von 10 und 18 sowie von 17 und 18 bei gleicher Leiteranzahl durch die Kernlöcher 19, 20 realisieren. Vorzugsweise wird das Windungszahlverhältnis von 10 und 18 grösser gewählt als das Verhältnis von 9 und 17, wobei die Windungszahlen von 9 und 10 gleich gross und die Zahl der Leiterbahnabschnitte 21, 23 und 22, 24 durch die beiden Kernlöcher 19, 20 identisch ist. Der Unterschied zwischen den beiden Verhältnissen richtet sich nach der gewünschten Nennübertragungsdämpfung vom Eingang 11 zum Stich 13 in dB, z. B. 15 dB. Der innenliegende, dem Kernschenkel 6 benachbarte Anfang der Spirale 17 ist durch einen Streifenleiter 17a mit der Leiterbahn 10 verbunden, während der Anfang der Leiterbahnspirale 18 mittels eines Streifenleiters 18a an die Leiterbahn 9 angeschlossen ist. Die Streifenleiter 17a und 18a sind an der Rückseite des Isolierträgers 1 angeordnet.

Der reelle Nachbildwiderstand 15 kann auf der Schaltung direkt mit integriert werden, und zwar entweder in einer gedruckten Technik entsprechend der Dünn- oder Dickschichttechnik, oder in Form eines einzulötenden oder einzuklebenden diskreten Bauelements. Wesentlich ist, dass der Nennwert des Widerstandes 15 nicht mit dem Wellenwiderstand des Systems identisch ist, sondern einen anderen Wert hat als der Wellenwiderstand. So kann bei einer Nennübertragungsdämpfung von 15 dB der Wert des Widerstandes 15 82 Ohm betragen, bei einem Wellenwiderstand $Z_0$ von 75 Ohm. Durch diese Massnahme lassen sich in Verbindung mit den ungleichen Windungszahlverhältnissen in der Spulenanordnung wesentlich höhere Dämpfungswerte der Übertragung vom Stich 13 zum Ausgang 12 erreichen.

Auf dem Isolierträger 1 sitzt ein weiterer, kleinerer Isolierträger 27, der zwischen dem Ferritkern 5 und den Anschlüssen 11, 13 angeordnet ist. Für diesen Träger eignen sich neben festen Materialien auch hochflexible dünne Isolierstoffe, die insbesondere dann eingesetzt werden, wenn der Isolierträger 1 an sich ausreichende Eigenstabilität aufweist. Der Isolierträger 27 ist auf seiner der Spulenanordnung 9, 17; 10, 18 abgekehrten Oberseite mit einem leitenden Belag 28 versehen, der im Ausführungsbeispiel rechteckige Form hat und so auf dem Isolierträger 27 angebracht ist, dass er Teile der Leiterbahnen im Bereich Eingang – Masse – Stich überdeckt. Der leitende Belag wird vorzugsweise im Druckverfahren direkt auf den Isolierträger 27 aufgebracht. Er kann aber auch aus einem aufgeklebten Leitermaterial, beispielsweise aus einer Kupferfolie, oder einem aufgeklebten, leiterbeschichteten Isolierblättchen bestehen.

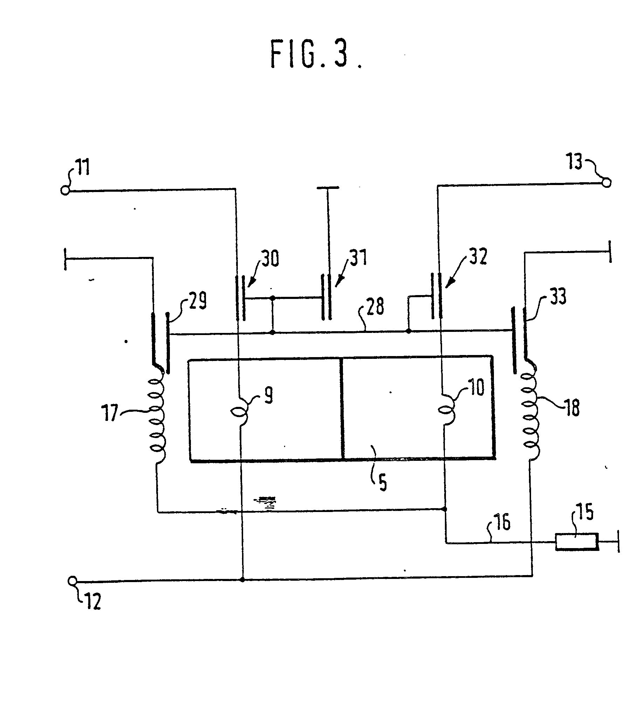

Der leitende Belag 28 ist durch den Isolierträger 27, welcher ein Dielektrikum darstellt, mit der Spulenanordnung kapazitiv gekoppelt. Die Leiterbahnen der Spulen und deren Anschlüsse realisieren, wie das NF-Ersatzschaltbild nach Fig. 3 zeigt, zusammen mit dem leitenden Belag 28 in Reihe geschaltete Kondensatoren 29 bis 33, zwischen Eingang 11, Masse, Stich 13 und Teilen der Leiterbahnen 9, 17; 10, 18. Durchkontaktierungen auf dem Isolierträger 27 sind nicht vorhanden.

Durch diese verteilten, in Reihe geschalteten Kondensatoren, erzeugt mit einem nicht kontaktierten, leitenden Belag, werden alle Parameter im mittleren und oberen Frequenzbereich in gewünschter Weise verändert. Durch geeignete geometrische Formgebung des leitenden Belags 28 und Verwendung bestimmter Schichtdicken des Dielektrikums 27 lassen sich für alle wesentlichen Parameter der Schaltung optimale Werte erzielen.

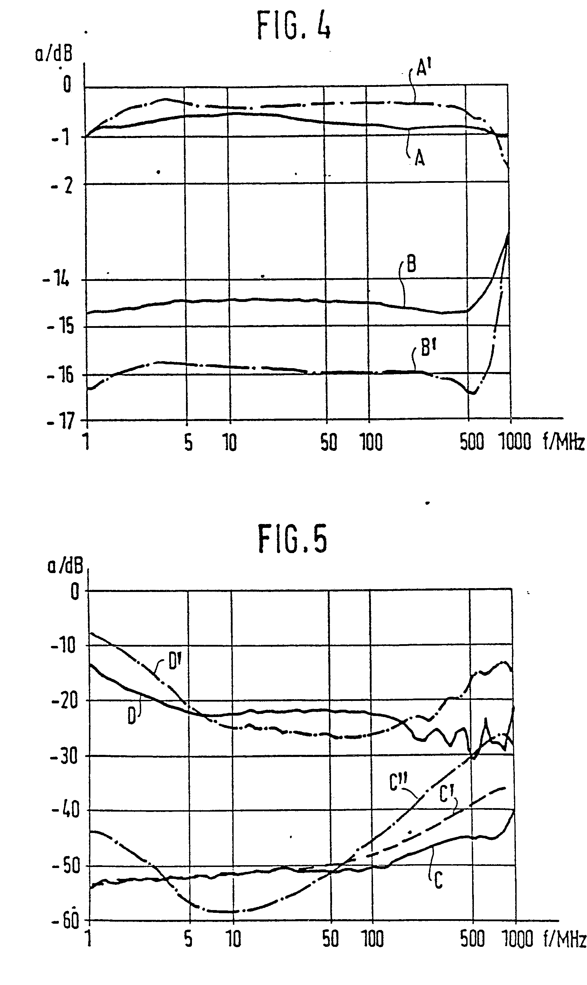

Die Diagramme nach den Fig. 4 und 5 stammen von 15 dB Übertragern, die hinsichtlich Breite, Abstand und Windungszahlverhältnis der Leiterbahnen unsymmetrisch sind. Die als Durchgang bezeichnete Übertragung zwischen Eingang 11 und Ausgang 12 ist über den gesamten Frequenzbereich nahezu linear, lediglich mit einem kleinen Abfall im Bereich der oberen Grenzfrequenz (Kennlinie A in Fig. 4). Die Kennlinie A' zeigt den Durchgang vergleichbarer, drahtgewickelter Übertrager. In Fig. 4 sind ausserdem die Anschlusskennlinien (Übertragung Eingang 11 – Stich 13) eingezeichnet. Die Kennlinie B gilt dabei für einen nach der Erfindung ausgebildeten Übertrager, die Kennlinie B' für einen drahtgewickelten Übertrager. Die im Diagramm nach Fig. 5 eingetragene Kennlinie C der Entkopplung zwischen Ausgang 12 und Stich 13 und umgekehrt verläuft bei einem mit dem Belag 28 versehenen Übertrager nahezu optimal. Dies zeigt ein Vergleich mit der Entkopplungskennlinie C' eines Übertragers ohne leitenden Belag 28 und mit der Entkopplungskennlinie C" eines drahtgewickelten Übertragers. In Fig. 5 sind ausserdem die Kennlinien D und D' für den erfindungsgemäss ausgebildeten Übertrager bzw. für einen drahtgewickelten Übertrager eingezeichnet.

## Patentansprüche

1. Hochfrequenz-Übertrager, insbesondere richtungsabhängiger Hochfrequenz-Breitbandübertrager, bestehend aus induktiven und kapazitiven Elementen, die als gedruckte Schaltungen ausgebildet sind, wobei die induktiven Elemente aus einer einen geschlossenen Ferritkern (5) aufweisenden Spulenanordnung bestehen, die in Form gedruckter Leiterbahnen (9, 10, 17, 18) auf einen Isolierträger (1) aufgebracht ist, dadurch gekennzeichnet, dass die kapazitiven Elemente einen weiteren, als Dielektrikum wirkenden Isolierträger (27) enthalten, der auf wenigstens einen Teil der Spulenanordnung (9, 10, 17, 18) aufgebracht ist und der auf seiner der Spulenanordnung (9, 10, 17, 18) abgekehrten Oberseite mit einem leitenden Belag (28) versehen ist, der mit keinem Schaltungspunkt elektrisch verbunden ist.

2. Übertrager mit einem Nachbildwiderstand, nach Anspruch 1, dadurch gekennzeichnet, dass der Nachbildwiderstand (15) auf dem die Leiterbahnen (9, 10, 17, 18) aufweisenden Isolierträger (1) sitzt und mittels eines Streifenleiters (16) an die Spulenanordnung angeschlossen ist.

3. Übertrager nach Anspruch 2, dadurch gekennzeichnet, dass der Nachbildwiderstand (15) einen von dem Wellenwiderstand des Systems abweichenden Widerstandswert hat.

4. Übertrager nach einem der vorhergehenden Ansprüche, dadurch gekennzeichnet, dass die Spulenanordnung mehrwindige Leiterspiralen (17, 18) hat, deren äusseres Ende (25 bzw. 26) an Masse geht.

5. Übertrager nach einem der vorhergehenden Ansprüche, dadurch gekennzeichnet, dass die Leiterbahnen (9, 10, 17, 18) unterschiedliche Bahnbreite und/oder unterschiedlichen Abstand voneinander haben.

## Claims

1. High frequency transformer, particularly a direction-dependent/high-frequency wideband transformer, consisting of inductive and capacitive elements which are constructed as printed circuits, in which arrangement the inductive elements consist of a coil arrangement exhibiting a closed ferrite core (5), which is applied in the form of printed conductor tracks (9, 10, 17, 18) to an insulating carrier (1), characterized in that the capacitive elements contain a further insulating carrier (27) which acts as dialectric and which is applied to at least one part of the coil arrangement (9, 10, 17, 18) and which is provided on its top facing away from the coil arrangement (9, 10, 17, 18) with a conductive coating (28) which is not electrically connected to any circuit point.

2. Transformer with a balancing resistor, according to claim 1, characterized in that the balancing resistor (15) is located on the insulating carrier (1) exhibiting the conductor tracks (9, 10, 17, 18) and is connected to the coil arrangement by means of a strip conductor (16).

3. Transformer according to claim 2, characterized in that the balancing resistor (15) has a resistance value which deviates from the characteristic impedance of the system.

4. Transformer according to one of the preceding claims, characterized in that the coil arrangement has multiturn conductor spirals (17, 18), the outer end (25 or 26 respectively) of which goes to earth.

5. Transformer accordig to one of the preceding claims, characterized in that the conductor tracks (9, 10, 17, 18) have different track widths and/or different spacing from one another.

## Revendications

1. Transformateur électrique notamment transformateur à bande large à haute fréquence, orienté composé d'éléments inductifs et capacitifs réalisés sous forme de circuits imprimés, les éléments inductifs se composant d'un dispositif de bobine à noyau de ferrite (5) fermé, dispositif réalisé sous la forme de chemin conducteur imprimé (9, 10, 17, 18) sur un support isolant (1), transformateur caratérisé en ce que les éléments capacitifs comportent un autre support isolant (27) fonctionnant comme diélectrique et qui est réalisé sur au moins une partie du dispositif de bobine (9, 10, 17, 18) et qui est muni sur la face supérieure opposée au dispositif de bobine (9, 10, 17, 18) d'un revêtement conducteur (28) qui n'est relié électriquement à aucun point du circuit.

2. Transformateur à résistance image selon la revendication 1, caractérisé en ce que la résistance image (15) se trouve sur le support isolant (1) muni des chemins conducteurs (9, 10, 17, 18) et est reliée au dispositif à bobine par un chemin conducteur (16).

3. Transformateur selon la revendication 2, caractérisé en ce que la résistance image (15) a une valeur différente de l'impédance caractéristique du système.

4. Transformateur selon l'une des revendications précédentes, caractérisé en ce que le dispositif de bobine possède des spirales conductrices à plusieurs spires (17, 18) dont l'extrémité extérieure (25, 26) est à la masse.

5. Transformateur selon l'une des revendications précédentes, caractérisé en ce que les chemins conducteurs (9, 10, 17, 18) ont une largeur et/ou un écartement différents.

# FIG. 1

# FIG. 2

# FIG.3.

0187771

# FIG. 4

# FIG.5